# EUROPEAN PATENT APPLICATION

(11) **EP 4 664 766 A1**
(43) Date of publication of application: **17.12.2025**
(21) Application number: 23927404.6
(22) Date of filing: 14.03.2023
(51) Int. Cl.: H03M 13/45, H03M 13/15, H04L 1/00

(54) **ERROR CORRECTION DEVICE, ERROR CORRECTION METHOD, CONTROL CIRCUIT, AND STORAGE MEDIUM**

(71) Applicant: MITSUBISHI ELECTRIC CORPORATION, Chiyoda-ku Tokyo 100-8310 (JP)
(72) Inventor: YOSHIDA, Hideo, Tokyo 100-8310 (JP); ISHII, Kenji, Tokyo 100-8310 (JP); ONOHARA, Kiyoshi, Tokyo 100-8310 (JP)
(74) Representative: Plasseraud IP
(86) International application number: PCT/JP2023/009894
(87) International publication number: WO 2024/189783

(57) **Abstract**

An error correction device (100) includes a hard decision value extraction unit (2) that extracts a hard decision value from a soft decision received-sequence containing soft decision information, and outputs, as a hard decision received-sequence, a hard decision value sequence that has been extracted; a test pattern position candidate selection unit (3) that determines, on the basis of the soft decision information, test pattern position candidates, which are each a position of application of a test pattern to the hard decision received-sequence; and a simulated correction operation unit (110) that performs, in parallel, generation of multiple test patterns to be applied at the test pattern position candidates, and error correction operations using the test patterns generated, on the hard decision received-sequence.

## Description

### Field

The present disclosure relates to an error correction device, an error correction method, a control circuit, and a storage medium.

### Background

One soft decision error correction decoding method that uses a block error correction code such as a Bose-Chaudhuri-Hocquenghem (BCH) code is a Chase decoding method (e.g., Non-Patent Literature 1). The Chase decoding method provides correction beyond the correction limit of an algebraic decoding method in such a manner that simulated correction operations using multiple test patterns are sequentially performed on the basis of soft decision information of a received sequence, after which a code sequence candidate having a highest correlation with the received sequence is selected from code sequence candidates obtained through trials of conventional algebraic error correction.

### Citation List

### Non-Patent Literature

Non-Patent Literature 1: David Chase, "A Class of Algorithms for Decoding Block Codes with Channel Measurement Information", IEEE Transactions on information theory, Vol. IT-18, No. 1, pp. 170-182, 1972

### Summary

### Technical Problem

The conventional Chase decoding method sequentially performs trials using test patterns. This presents a problem in that a desired throughput is hard to be achieved when the conventional method is applied to, for example, an error correction device for use in optical transmission with a transmission speed on the order of gigabits per second. Providing an increase in the speed of decoding operation is accordingly demanded.

The present disclosure has been made in view of the foregoing, and it is an object of the present disclosure to provide an error correction device that provides an increase in the speed of decoding operation.

### Solution to Problem

In order to solve the above-described problems and achieve the object, an error correction device according to the present disclosure includes: a hard decision value extraction unit to extract a hard decision value from a soft decision received-sequence, the soft decision received-sequence containing soft decision information, and to output, as a hard decision received-sequence, a hard decision value sequence that has been extracted; a test pattern position candidate selection unit to determine test pattern position candidates on a basis of the soft decision information, the test pattern position candidates each being a position of application of a test pattern to the hard decision received-sequence; and a simulated correction operation unit to perform, in parallel, generation of a plurality of test patterns to be applied at the test pattern position candidates, and error correction operations using the test patterns generated, on the hard decision received-sequence.

### Advantageous Effects of Invention

An error correction device according to the present disclosure provides an advantage in capability of providing an increase in the speed of decoding operation.

### Brief Description of Drawings

FIG. 1 is a diagram illustrating an exemplary configuration of an error correction device according to a first embodiment.
FIG. 2 is a flowchart illustrating an example of operation of the error correction device according to the first embodiment.
FIG. 3 is a diagram illustrating an exemplary configuration of an error correction device according to a second embodiment.
FIG. 4 is a flowchart illustrating an example of operation of the error correction device according to the second embodiment.
FIG. 5 is a diagram illustrating an example of processing circuitry that implements part or all of components of the error correction devices.

### Description of Embodiments

An error correction device, an error correction method, a control circuit, and a storage medium according to embodiments of the present disclosure will be described in detail below with reference to the drawings.

### First Embodiment.

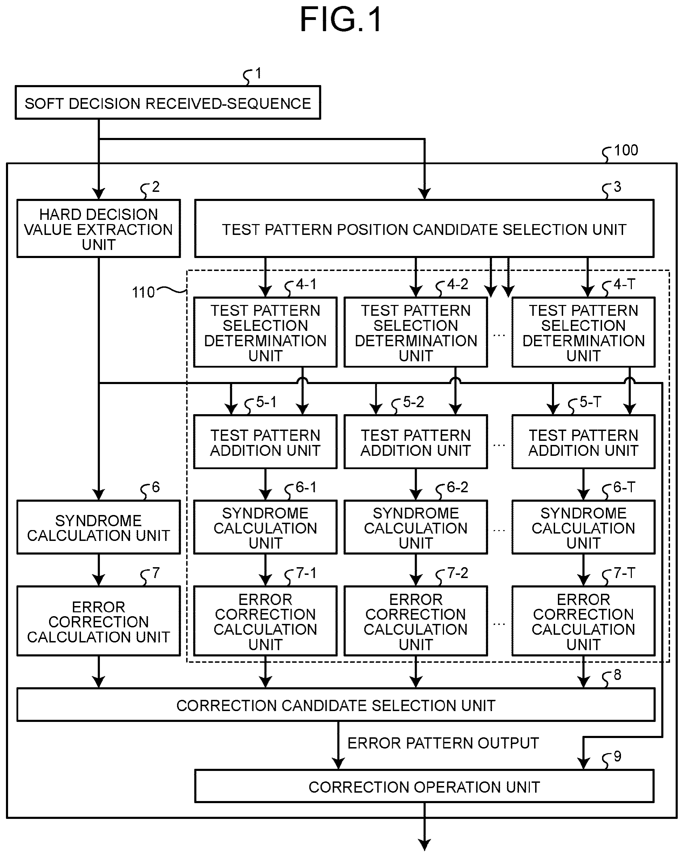

FIG. 1 is a diagram illustrating an exemplary configuration of an error correction device 100 according to a first embodiment. The error correction device 100 is, for example, installed in a communication device included in an optical transmission system, and performs error correction decoding on an information sequence obtained by performing a soft decision on a received sequence (the above information sequence referred to hereinafter as soft decision received-sequence). The error correction device 100 corrects an error of the soft decision received-sequence by a Chase decoding operation.

As illustrated in FIG. 1, the error correction device 100 includes a hard decision value extraction unit 2, a test pattern position candidate selection unit 3, test pattern selection determination units 4-1 to 4-T, test pattern addition units 5-1 to 5-T, syndrome calculation units 6 and 6-1 to 6-T, error correction calculation units 7 and 7-1 to 7-T, a correction candidate selection unit 8, and a correction operation unit 9, where T is an integer greater than or equal to 2. The error correction device 100 receives a soft decision received-sequence 1 containing soft decision information such as a log-likelihood ratio (LLR). In the error correction device 100, the soft decision received-sequence 1 is input to the hard decision value extraction unit 2 and to the test pattern position candidate selection unit 3. The test pattern position candidate selection unit 3 performs weighting in descending order of probability of error, on the basis of the soft decision information such as an LLR, to thus select test pattern position candidates. Note that the test pattern selection determination units 4-1 to 4-T select respective different error patterns on the basis of the order of weighting performed by the test pattern position candidate selection unit 3. The test pattern addition units 5-1 to 5-T perform same processing in parallel on the test patterns selected by the test pattern selection determination units 4-1 to 4-T. The syndrome calculation units 6-1 to 6-T and the error correction calculation units 7-1 to 7-T operate similarly. The test pattern selection determination units 4-1 to 4-T, the test pattern addition units 5-1 to 5-T, the syndrome calculation units 6-1 to 6-T, and the error correction calculation units 7-1 to 7-T together form a simulated correction operation unit 110, which performs, in parallel, multiple simulated correction operations using multiple respective test patterns according to the Chase decoding method.

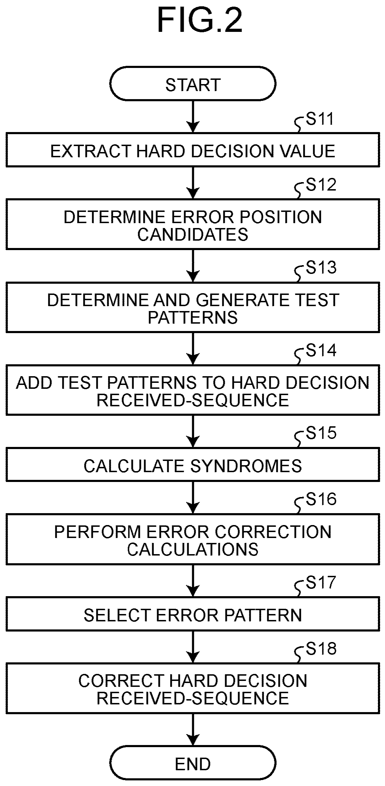

Operations of components of the error correction device 100 will next be described with reference to FIGS. 1 and 2. FIG. 2 is a flowchart illustrating an example of operation of the error correction device 100 according to the first embodiment.

First, in the error correction device 100, the hard decision value extraction unit 2 extracts a hard decision value from the soft decision received-sequence 1 (step S11). A hard decision value sequence extracted by the hard decision value extraction unit 2 is input to each of the syndrome calculation unit 6, the test pattern addition units 5-1 to 5-T, and the correction operation unit 9, as a hard decision received-sequence.

In addition, the test pattern position candidate selection unit 3 performs sorting by weighting, for example, in descending order of probability of error, on the basis of the soft decision information such as an LLR, to thus determine test pattern position candidates for the position of application of a test pattern to the hard decision received-sequence extracted by the hard decision value extraction unit 2 (step S12). In the present embodiment, the test pattern position candidate selection unit 3 ultimately determines S test pattern position candidates (i.e., test pattern position candidates for S points), where S is an integer greater than or equal to 2. The test pattern position candidate selection unit 3 determines the test pattern position candidates on the basis of the soft decision information contained in the soft decision received-sequence 1.

Note that although FIG. 2 illustrates the workflow as performing step S12 after step S11, step S11 and step S12 are performed in parallel.

Next, the test pattern selection determination units 4-1 to 4-T generate T test patterns from the S position candidates determined by the test pattern position candidate selection unit 3 (step S13). Specifically, the test pattern selection determination units 4-1 to 4-T select respective different test patterns each as the test pattern to be added to the hard decision received-sequence extracted by the hard decision value extraction unit 2. In this respect, due to the number of the test pattern position candidates in the present embodiment being S, the maximum value of T is 2⁵-1, where T is equivalent to the number of the test patterns. Note that the number of the test patterns to be selected by the test pattern selection determination units 4-1 to 4-T can even be limited on the basis of the soft decision information contained in the soft decision received-sequence 1. For example, the selection operation may be performed in such a manner that one or more test pattern positions having a likelihood greater than or equal to a predetermined threshold are eliminated, and test patterns corresponding to other test pattern positions are selected by the test pattern selection determination units 4-1 to 4-T. In this case, part of the test pattern selection determination units 4-1 to 4-T select and output respective different test patterns. Alternatively, when the test pattern selection determination units 4-1 to 4-T select respective fixed test patterns, that is, when the test pattern selection determination units 4-1 to 4-T output test patterns always on the basis of same sets of S position candidates obtained by sorting by weighting, the test pattern selection determination units 4-1 to 4-T are only connecting lines.

Next, the test pattern addition units 5-1 to 5-T add the test patterns to the hard decision received-sequence (step S14). Specifically, the test pattern addition units 5-1 to 5-T add, by an exclusive OR operation, the respective test patterns selected by the test pattern selection determination units 4-1 to 4-T disposed upstream thereof, to the hard decision received-sequence that has been input from the hard decision value extraction unit 2. In this operation, the test pattern addition units 5-1 to 5-T add, by an exclusive OR operation, the bits of the test patterns to the hard decision values respectively corresponding to the test pattern positions.

Next, the syndrome calculation units 6 and 6-1 to 6-T perform syndrome calculations (step S15). Specifically, the syndrome calculation unit 6 calculates a syndrome of the hard decision received-sequence that has been input from the hard decision value extraction unit 2. The syndrome calculation units 6-1 to 6-T calculate respective syndromes of the hard decision received-sequences that have been obtained by addition of the test patterns performed by the test pattern addition units 5-1 to 5-T disposed upstream thereof. Note that the syndrome calculation units 6 and 6-1 to 6-T perform a same calculation operation.

Next, the error correction calculation units 7 and 7-1 to 7-T perform error correction calculations (step S16). Specifically, the error correction calculation unit 7 performs an error correction calculation on the hard decision received-sequence using the syndrome calculated by the syndrome calculation unit 6. The error correction calculation units 7-1 to 7-T perform error correction calculations on the hard decision received-sequences that have been obtained by addition of the test patterns performed by the test pattern addition units 5-1 to 5-T, using the syndromes calculated by the syndrome calculation units 6-1 to 6-T disposed upstream thereof. In this operation, when an error correction calculation results in an error position that matches the test pattern position, correction is not performable. In the error correction calculations, the error correction calculation units 7 and 7-1 to 7-T extract error patterns, which are transmission code candidates.

Next, the correction candidate selection unit 8 selects an error pattern (step S17). Specifically, the correction candidate selection unit 8 selects one of the error patterns extracted by the respective error correction calculation units 7 and 7-1 to 7-T. The correction candidate selection unit 8, for example, calculates a total value of the likelihood of the bits of the error pattern for each of the multiple error patterns, selects the error pattern that gives the lowest total value, and outputs the selected error pattern to the correction operation unit 9.

Next, the correction operation unit 9 corrects the hard decision received-sequence (step S18). Specifically, the correction operation unit 9 adds, by a bitwise exclusive OR operation, the correction pattern that has been input from the correction candidate selection unit 8 to the hard decision received-sequence input from the hard decision value extraction unit 2 to thus cancel the error. The correction operation unit 9 outputs the hard decision received-sequence obtained by error correction.

As described above, the error correction device 100 according to the present embodiment performs, in parallel, the simulated correction operations using a Chase decoding method, specifically, operations of selecting test patterns to be used, operations of adding the test patterns to the hard decision received-sequence, syndrome calculation operations, and error correction calculation operations of extracting error patterns. This can reduce the required time for decoding operation. That is, the error correction device 100 can provide an increase in the speed of decoding operation.

### Second Embodiment.

The error correction device 100 according to the first embodiment described above is configured to perform a sequence of Chase decoding operations in parallel to thereby reduce the required time for processing to thus provide an increase in the speed of decoding operation. An embodiment will next be described that reduces the size of the circuit that performs test pattern processing included in each of the operations to be performed in parallel.

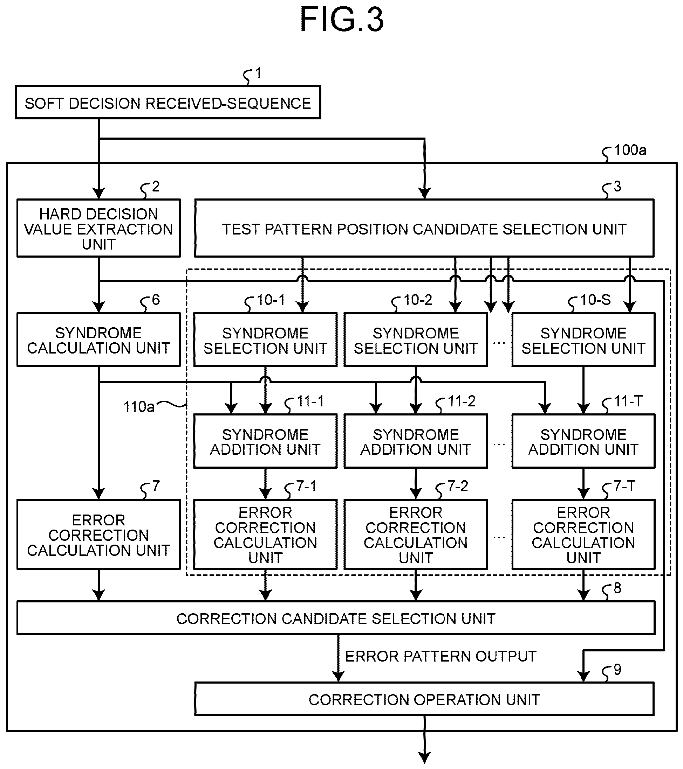

FIG. 3 is a diagram illustrating an exemplary configuration of an error correction device 100a according to a second embodiment. In FIG. 3, components common to the error correction device 100 according to the first embodiment illustrated in FIG. 1 are designated by like reference characters. The components designated by reference characters the same as those in FIG. 1 operate similarly to the corresponding components of the first embodiment, and description thereof will therefore be omitted.

The error correction device 100a includes the hard decision value extraction unit 2, the test pattern position candidate selection unit 3, the syndrome calculation unit 6, syndrome selection units 10-1 to 10-S, syndrome addition units 11-1 to 11-T, the error correction calculation units 7 and 7-1 to 7-T, the correction candidate selection unit 8, and the correction operation unit 9. Note that the syndrome selection units 10-1 to 10-S, the syndrome addition units 11-1 to 11-T, and the error correction calculation units 7-1 to 7-T together form a simulated correction operation unit 110a.

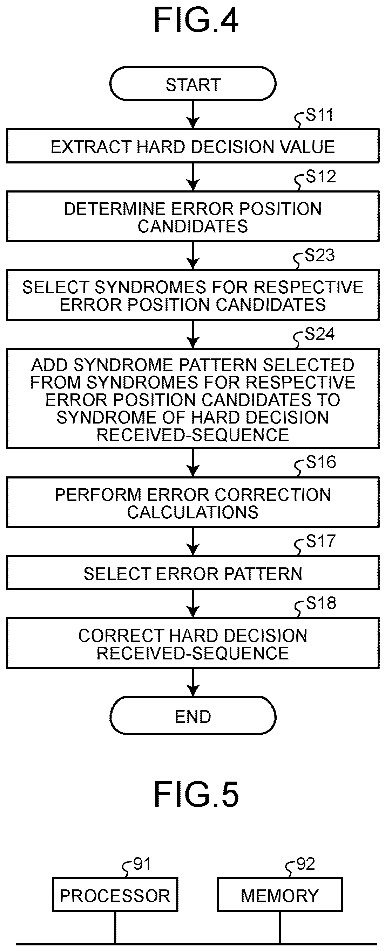

Operations of components of the error correction device 100a will next be described with reference to FIGS. 3 and 4. FIG. 4 is a flowchart illustrating an example of operation of the error correction device 100a according to the second embodiment. In FIG. 4, same step numbers are assigned to operations common to the flowchart illustrated in FIG. 2. The flowchart illustrated in FIG. 4 differs from the flowchart illustrated in FIG. 2 in that steps S13 to S15 are replaced with steps S23 and S24. The operations given the same step numbers as the step numbers of FIG. 2 are similar to the corresponding operations in the first embodiment, and description thereof will therefore be omitted.

In the error correction device 100a, after the operations of step S11 and step S12 are performed, the syndrome calculation unit 6 calculates the syndrome, and the syndrome selection units 10-1 to 10-S select syndrome patterns for the respective S position candidates selected by the test pattern position candidate selection unit 3 (step S23). At this step S23, the syndrome calculation unit 6 performs operation similar to the operation in the first embodiment to calculate the syndrome. The syndrome selection units 10-1 to 10-S calculate respective different syndrome patterns on the basis of the S test pattern position candidates. Specifically, the syndrome selection units 10-1 to 10-S are each associated with one of the S test pattern positions, each calculate the syndrome corresponding to the test pattern position associated therewith, and each output the syndrome as the syndrome pattern. Although the syndrome selection units 10-1 to 10-S are capable of calculating the syndromes by performing calculation operation similar to that of the syndrome calculation units 6-1 to 6-T of the first embodiment, the syndrome pattern corresponding to a test pattern position is output in the present embodiment, for example, by addressing a look-up table using position information of the test pattern position, to thereby reducing the circuit size. For example, in a case of an extended BCH code having a code length of 256 bits and an information bit length of 239 bits, the output syndrome pattern has a length of 16 bits excluding the extended parity in a 256-word format with an 8-bit input address. In this case, the above functionality can be provided by disposing as few as S circuits in parallel that output syndrome patterns respectively corresponding to the test pattern positions.

Next, the syndrome addition units 11-1 to 11-T add the syndrome pattern(s) from one or multiple ones of the syndrome selection units 10-1 to 10-S to the syndrome of the hard decision received-sequence (step S24). Specifically, the syndrome addition units 11-1 to 11-T each add, by an exclusive OR operation, syndrome pattern(s) output from applicable one or ones of the syndrome selection units 10-1 to 10-S disposed upstream thereof, to the syndrome of the hard decision received-sequence output from the syndrome calculation unit 6. The syndrome addition units 11-1 to 11-T output outputs similar to the outputs from the syndrome calculation units 6-1 to 6-T of the error correction device 100 according to the first embodiment.

A specific example of calculations performed by the syndrome addition units 11-1 to 11-T will next be given. As one example, a case of an extended BCH code having a code length of 256 bits and an information bit length of 239 bits will be described. In this case, when only one of the test pattern positions determined by the test pattern position candidate selection unit 3 is used as the target of the test pattern, the calculation performed by the syndrome addition unit 11 (i.e., one of the syndrome addition units 11-1 to 11-T) corresponding to the test pattern will be bitwise exclusive OR addition of 16 bits of the output of a syndrome selection unit 10 (i.e., one of the syndrome selection units 10-1 to 10-S) disposed upstream thereof and 16 bits among 17 bits of the output of the syndrome calculation unit 6 based on the output of the hard decision value extraction unit 2. A syndrome based on the extended parity bit can be obtained by an operation of inverting 1 and 0 of the extended parity bit output from the syndrome calculation unit 6. Even when the S test patterns at the maximum are for simulation at K positions, the operations are similarly performed in which 16 bits are each added by a bitwise exclusive OR operation, and the syndrome based on the extended parity bit is output after inverting 1 and 0 when K is an odd number, and is output without change when K is an even number.

As described above, the error correction device 100a according to the present embodiment includes the syndrome selection units 10-1 to 10-S corresponding in a one-to-one correspondence to the respective S test pattern positions, and adds, by the syndrome addition units 11-1 to 11-T, the syndrome patterns output by the syndrome selection units 10-1 to 10-S to the syndrome output by the syndrome calculation unit 6. The error correction device 100 according to the first embodiment described above is configured to perform the syndrome calculation after addition of test patterns to the hard decision received-sequence, and thus requires bitwise computation operation. This requires a large circuit size. In contrast, the configuration of the present embodiment can reduce the circuit size as compared to the first embodiment.

For example, even when the syndrome selection units 10-1 to 10-S are each configured the same as the syndrome calculation unit 6, the circuit has a small size due to the significantly smaller number of the test pattern positions, which is S, than the number of the test patterns, which is T. In addition, due to the significantly shorter bit length of the syndrome patterns than the bit length of the hard decision received-sequence, the syndrome addition units 11-1 to 11-T perform fewer exclusive OR addition operations than the exclusive OR addition operations performed by the test pattern addition units 5-1 to 5-T of the error correction device 100 according to the first embodiment. This provides a smaller circuit size.

Hardware configurations of the error correction devices 100 and 100a described in the embodiments will next be described. The error correction devices 100 and 100a are implemented in similar hardware elements. An exemplary hardware configuration of the error correction device 100a will herein be described as an example.

The hard decision value extraction unit 2, the test pattern position candidate selection unit 3, the syndrome calculation unit 6, the error correction calculation units 7 and 7-1 to 7-T, the syndrome selection units 10-1 to 10-S, the syndrome addition units 11-1 to 11-T, the correction candidate selection unit 8, and the correction operation unit 9 of the error correction device 100a are implemented in processing circuitry that is a dedicated hardware element, specifically, processing circuitry that is a single circuit, a set of multiple circuits, a programmed processor, a parallel programmed processor, an application specific integrated circuit (ASIC), a field programmable gate array (FPGA), or a combination thereof.

In addition, part or all of the components of the error correction device 100a, i.e., part or all of a group of the hard decision value extraction unit 2, the test pattern position candidate selection unit 3, the syndrome calculation unit 6, the error correction calculation units 7 and 7-1 to 7-T, the syndrome selection units 10-1 to 10-S, the syndrome addition units 11-1 to 11-T, the correction candidate selection unit 8, and the correction operation unit 9 may be implemented in processing circuitry including a processor 91 and a memory 92 illustrated in FIG. 5. FIG. 5 is a diagram illustrating an example of the processing circuitry that implements part or all of the components of the error correction device 100a. The processor 91 is a central processing unit (CPU) (also known as processing unit, computing unit, microprocessor, microcomputer, processor, and digital signal processor (DSP)). The memory 92 is, for example, a random access memory (RAM), a read-only memory (ROM), a flash memory, an erasable programmable read-only memory (EPROM), an electrically erasable programmable read-only memory (EEPROM) (registered trademark), or the like.

When part or all of the components of the error correction device 100a are implemented by the combination of the processor 91 and the memory 92 illustrated in FIG. 5, the memory 92 stores a program for providing the operation of part or all of the hard decision value extraction unit 2, the test pattern position candidate selection unit 3, the syndrome calculation unit 6, the error correction calculation units 7 and 7-1 to 7-T, the syndrome selection units 10-1 to 10-S, the syndrome addition units 11-1 to 11-T, the correction candidate selection unit 8, and the correction operation unit 9 of the error correction device 100a. This program is read and executed by the processor 91 to thereby implement part or all of the hard decision value extraction unit 2, the test pattern position candidate selection unit 3, the syndrome calculation unit 6, the error correction calculation units 7 and 7-1 to 7-T, the syndrome selection units 10-1 to 10-S, the syndrome addition units 11-1 to 11-T, the correction candidate selection unit 8, and the correction operation unit 9 of the error correction device 100a. Note that when part of the components of the error correction device 100a are implemented by the combination of the processor 91 and the memory 92, the other ones of the components are implemented by a single circuit, a set of multiple circuits, or the like as described above. That is, the error correction device 100a may be implemented in such a manner that part of the components thereof are implemented in a dedicated hardware element, and the other ones of the components are implemented by the combination of the processor 91 and the memory 92 illustrated in FIG. 5.

When part or all of the components of the error correction device 100a are implemented by the combination of the processor 91 and the memory 92, the foregoing program to be stored in the memory 92 may be provided to a user and/or the like as stored in a storage medium such as, for example, a compact disc (CD)-ROM or a digital versatile disc (DVD)-ROM, or provided via a network.

The configurations described in the foregoing embodiments are merely examples. These configurations may be combined with another known technology, and configurations of different embodiments may be combined together. Moreover, part of such configurations may be omitted and/or modified without departing from the spirit.

### Reference Signs List

1 soft decision received-sequence; 2 hard decision value extraction unit; 3 test pattern position candidate selection unit; 4-1 to 4-T test pattern selection determination unit; 5-1 to 5-T test pattern addition unit; 6, 6-1 to 6-T syndrome calculation unit; 7, 7-1 to 7-T error correction calculation unit; 8 correction candidate selection unit; 9 correction operation unit; 10-1 to 10-S syndrome selection unit; 11-1 to 11-T syndrome addition unit; 100, 100a error correction device; 110, 110a simulated correction operation unit.

## Claims

1. An error correction device comprising:
a hard decision value extraction unit to extract a hard decision value from a soft decision received-sequence, the soft decision received-sequence containing soft decision information, and to output, as a hard decision received-sequence, a hard decision value sequence that has been extracted;
a test pattern position candidate selection unit to determine test pattern position candidates on a basis of the soft decision information, the test pattern position candidates each being a position of application of a test pattern to the hard decision received-sequence; and
a simulated correction operation unit to perform, in parallel, generation of a plurality of test patterns to be applied at the test pattern position candidates, and error correction operations using the test patterns generated, on the hard decision received-sequence.

2. The error correction device according to claim 1, wherein
the simulated correction operation unit includes:
a plurality of test pattern selection determination units to generate respective different ones of the test patterns;
a plurality of test pattern addition units each associated with one of the plurality of test pattern selection determination units to add a corresponding one of the test patterns that has been generated by the associated one of the test pattern selection determination units, to the hard decision received-sequence;
a plurality of syndrome calculation units each associated with one of the plurality of test pattern addition units to calculate a syndrome of the hard decision received-sequence that has been obtained by addition of a corresponding one of the test patterns performed by the associated one of the test pattern addition units; and
a plurality of error correction calculation units each associated with one of the plurality of syndrome calculation units to perform an error correction calculation using the syndrome calculated by the associated one of the syndrome calculation units.

3. The error correction device according to claim 1, wherein
the simulated correction operation unit includes:
a plurality of syndrome selection units each associated with one of the test pattern position candidates to calculate a syndrome pattern, the syndrome pattern being a syndrome corresponding to the associated one of the test pattern position candidates;
a plurality of syndrome addition units to each add one or more of the syndrome patterns calculated by the plurality of respective syndrome selection units, to a syndrome of the hard decision received-sequence; and
a plurality of error correction calculation units each associated with one of the plurality of syndrome addition units to perform an error correction calculation using the syndrome of the hard decision received-sequence that has been obtained by addition of the corresponding one or ones of the syndrome patterns performed by the associated one of the syndrome addition units.

4. An error correction method to be performed by an error correction device that performs soft decision error correction decoding, the error correction method comprising:
a hard decision value extraction step of extracting a hard decision value from a soft decision received-sequence, the soft decision received-sequence containing soft decision information, and of outputting, as a hard decision received-sequence, a hard decision value sequence that has been extracted;
a test pattern position candidate selection step of determining test pattern position candidates on a basis of the soft decision information, the test pattern position candidates each being a position of application of a test pattern to the hard decision received-sequence; and
a simulated correction step of performing, in parallel, generation of a plurality of test patterns to be applied at the test pattern position candidates, and error correction operations using the test patterns generated, on the hard decision received-sequence.

5. The error correction method according to claim 4, wherein
the simulated correction step includes:
a syndrome selection step of performing, in parallel, operations of calculation of a syndrome pattern, the operations of calculation each associated with one of the test pattern position candidates, the syndrome pattern being a syndrome corresponding to the associated one of the test pattern position candidates;
a syndrome addition step of performing, in parallel, operations of addition of one or more of the syndrome patterns calculated in the syndrome selection step, to a syndrome of the hard decision received-sequence; and
an error correction calculation step of performing, in parallel, error correction calculations using the syndromes of the plurality of respective hard decision received-sequences that have been obtained by addition of the syndrome patterns in the syndrome addition step.

6. A control circuit for controlling an error correction device that performs soft decision error correction decoding, the control circuit causing the error correction device to perform:
a first step of extracting a hard decision value from a soft decision received-sequence, the soft decision received-sequence containing soft decision information, and of outputting, as a hard decision received-sequence, a hard decision value sequence that has been extracted;
a second step of determining test pattern position candidates on a basis of the soft decision information, the test pattern position candidates each being a position of application of a test pattern to the hard decision received-sequence; and
a third step of performing, in parallel, generation of a plurality of test patterns to be applied at the test pattern position candidates, and error correction operations using the test patterns generated, on the hard decision received-sequence.

7. A storage medium storing a program for controlling an error correction device that performs soft decision error correction decoding, wherein
the program causes the error correction device to perform:
a first step of extracting a hard decision value from a soft decision received-sequence, the soft decision received-sequence containing soft decision information, and of outputting, as a hard decision received-sequence, a hard decision value sequence that has been extracted;
a second step of determining test pattern position candidates on a basis of the soft decision information, the test pattern position candidates each being a position of application of a test pattern to the hard decision received-sequence; and
a third step of performing, in parallel, generation of a plurality of test patterns to be applied at the test pattern position candidates, and error correction operations using the test patterns generated, on the hard decision received-sequence.
